# EUROPÄISCHE PATENTANMELDUNG

(11) **EP 4 779 736 A1**
(43) Veröffentlichungstag der Anmeldung: **22.07.2026**
(21) Anmeldenummer: 26152925.9
(22) Anmeldetag: 20.01.2026
(51) Int. Cl.: H01M 10/0525, H01M 10/48

(54) **VERFAHREN ZUM ÜBERWACHEN EINES ENERGIESPEICHERS**

(30) Priorität: 20.01.2025 AT 500222025
(71) Anmelder: AIT Austrian Institute of Technology GmbH, 1210 Wien (AT)
(72) Erfinder: Glanz, Gregor, 1020 Wien (AT); Koller, Markus, 2301 Groß-Enzersdorf (AT)
(74) Vertreter: Wildhack & Jellinek Patentanwälte GmbH

(57) **Zusammenfassung**

Verfahren zum Bestimmen eines physischen Zustands einer Batterie (1), wobei die Batterie (1) eine Lithium-Ionen Batterie ist und eine Außenseite aufweist, wobei mechanische Wellen im Frequenzbereich von etwa 5 kHz bis etwa 100 kHz mittels mindestens eines Emitters (T1), der auf der Außenseite der Batterie aufgebracht ist, ausgesendet und die Wellen anschließend von mindestens einem ersten Empfänger (T2, T3), der in einem vorbestimmten Abstand (d) vom Emitter auf der Außenseite der Batterie aufgebracht ist, empfangen werden, umfassend die weiteren Schritte: Zuführen der empfangenen Wellen zu einer Auswerteeinrichtung, Auswerten der empfangenen Wellen hinsichtlich ihrer Ausbreitungsgeschwindigkeit und/oder ihrer Time of Flight (TOF) zwischen Emitter (T1) und Empfänger (T2, T3), Auswerten der empfangenen Wellen hinsichtlich ihrer Signalamplituden, sowie Errechnen des Zeitpunkts des Anfanges und/oder das Stadium von Lithiumplating der Batterie (1) auf der Basis dieser Auswertungen.

## Beschreibung

Die Erfindung betrifft ein Verfahren zum Bestimmen eines physischen Zustands einer Batterie.

Lithium-Ionen Batterien (LIB) bestehen aus einer positiven Elektrode (Kathode) und einer negativen Elektrode (Anode). Zwischen diesen beiden befindet sich der ionenleitende Elektrolyt, welcher es ermöglicht, dass die Ionen von der einen Elektrode zur anderen transportiert werden können. Ein weiterer Bestandteil einer LIB ist der Separator, der sich ebenfalls zwischen den beiden Elektroden befindet und somit eine elektrische Trennung ermöglicht. Beim Laden bzw. Entladen werden Lithium-Ionen als Gastatome in dem Wirtsgitter der jeweiligen Elektrode gespeichert bzw. herausgelöst. Während des Entladeprozesses geben die Lithiumatome, welche in der Anode interkaliert sind, aufgrund des Potentialunterschiedes Elektronen ab, welche über den externen Stromkreis zur Kathode wandern. Zur selben Zeit wandern, die sich herausgelösten (deinterkalierten) Lithium-Ionen von der Anode durch den Separator zur Kathode und lagern sich dort erneut im Wirtsgitter ein (Interkalation). Beim Ladevorgang findet der umgekehrte Prozess statt. Aufgrund der Interkalation bzw. Deinterkalation von Lithium-Ionen verändern die Aktivmaterialien während des Zyklisierens ihre mechanischen Eigenschaften. Die wohl offensichtlichste mechanische Eigenschaftsänderung während eines Ladevorgangs, ist die sich verändernde Dicke. Daneben gibt es auch andere mechanische Veränderungen. Zum Beispiel ändert sich auch der Elastizitätsmodul der Aktivmaterialien, während dieses Vorgangs.

Wird eine LIB außerhalb der vorgesehenen Betriebsparameter (Temperatur, Stromrate, Zellspannung etc.) verwendet oder weist diese einen Produktionsfehler auf, kann es vorkommen, dass unerwünschte Nebenreaktionen während der Benutzung auftreten. Einer dieser Effekte ist der sogenannte Prozess des Lithiumplatings, welcher vor allem bei niedrigen Temperaturen und erhöhten Ladeströmen begünstigt wird. Dieser chemische Prozess tritt vor allem an der Anode der Batterie auf und führt dazu, dass sich metallisches Lithium an der Partikeloberfläche abscheidet anstatt zu interkalieren. Daraus folgt, dass das zur Verfügung stehende Lithium weniger wird und somit, die LIB an Kapazität verliert (Alterung). Findet dieser Prozess häufiger statt (mehrmaliges Laden bzw. Entladen), wiederholt sich die Anlagerung von metallischem Lithium an der Oberfläche der Anode. Diese Verteilung findet jedoch inhomogen statt und verursacht eine Bildung von Mikrostrukturen, so genannten Dendriten. Im weiteren Verlauf können diese ihr Volumen so stark erhöhen, dass damit der Separator durchdrungen werden kann und dadurch ein Kurzschluss entstehen kann. Dies stellt ein erhebliches Sicherheitsrisiko dar, da ein Kurzschluss zu einem sogenannten Thermal-Runaway führt und somit eine Explosion bzw. einen Brand hervorrufen kann. Neben den beschriebenen Effekten hat dieser Prozess ebenfalls zur Folge, dass sich die mechanischen Eigenschaften der LIB ändern, wohingegen charakteristische Werte wie zum Beispiel die Zellspannung, sich während des Zyklisierens weitgehend normal verhält.

In bekannten Anwendungsbereichen, wo LIB als Energiespeicher verwendet werden, übernimmt ein Batteriemanagementsystem (BMS) die Aufgabe zur Überwachung des aktuellen Status der LIB. Dieses verwendet dafür vor allem die elektrischen bzw. elektro-chemischen Eigenschaften, welche sich unter anderem aus der Zellspannung, dem Lade-/Entladestrom, der geladenen Kapazität bzw. Energie und anderen charakteristischen Werten einer Batterie ergeben. Diese Werte ermöglichen dem BMS, den aktuellen Ladezustand (State of Charge SOC), den Gesundheitszustand (State of Health SOH) und den Zustand der Sicherheit (State of Safety SOS) - zusammengefasst als State of X (SOX) bezeichnet, zu ermitteln. Es gibt verschiedene Möglichkeiten, wie über diese elektrischen Eigenschaften einer LIB der State of X (SOX) präzise festgestellt werden kann. Diese Methoden basieren jedoch nur auf dem elektrischen Verhalten der Batterie, welche gegebenenfalls mit Daten von Temperatursensoren kombiniert werden. Wie zuvor beschrieben, ändern sich die mechanischen Eigenschaften der LIB während des Ladens und Entladens und daher ist es möglich durch Messung dieser mechanischen Eigenschaften ebenfalls Informationen über den aktuellen Zustand (SOX) der LIB zu erhalten.

Bei der WO2022038237A1 handelt es sich um elektrochemische Impedanzspektroskopie, auch EIS genannt. Dabei wird eine Wechselspannung oder ein Wechselstrom an die Batterie angelegt und der Wechselstromwiderstand bzw. die Impedanz bestimmt. Meist wird dabei die Frequenz der angelegten Spannung bzw. des angelegten Stroms variiert, um somit Aussagen über das Impedanzverhalten über ein großes Frequenzfenster abzubilden. Dadurch können Informationen über die Material- bzw. Systemeigenschaften, wie unter anderem auch Lithiumplating gewonnen werden. Nachteilig ist, dass für die Durchführung der EIS-Messung der Lade- bzw. Entladevorgang angehalten werden muss. Dementsprechend kann die Detektion nur zu definierten Momenten durchgeführt werden und daher kann der exakte Startzeitpunkt des Lithiumplatings nicht bestimmt werden - somit kommt es oftmals schon zu erheblichen Lithium-Plating, bevor es erkannt und der Ladevorgang abgebrochen/adaptiert werden kann. Um detaillierte Aussagen für dieses Messverfahren durchführen zu können, ist zudem in aufwendiger Weise eine hochauflösende Messelektronik notwendig, welche zu erhöhten Kosten in der Anwendung führt. Weiters muss der Energiespeicher zuvor genau mittels der EIS-Methode charakterisiert werden, um die Veränderungen in der Impedanz, welche durch Lithium-plating hervorgerufen werden, feststellen zu können, was ebenso nachteilig ist.

Die US20230046633A1 zeigt ein Verfahren, Lithiumplating anhand der Zellspannung bzw. der Open Circuit Voltage (OCV) des Energiespeichers zu ermitteln. Dabei werden definierte Lade- und Entladeprozesse durchgeführt, um im Anschluss die aufgezeichneten Spannungskurven der LIB miteinander zu vergleichen, um somit Lithiumplating zu detektieren. Der Nachteil dieser Lehre ist, dass der genaue Startzeitpunkt des unerwünschten chemischen Prozesses nicht festgestellt wird, sondern ausschließlich erkannt wird, dass dieser bereits stattgefunden hat. Weiters muss auch bei dieser Methode, der für die Anwendung vorgesehene Ladevorgang ausgesetzt werden, um darauffolgend einen speziell für die Detektion von Lithiumplating definierten Testplan durchzuführen. Die Wahrscheinlichkeit Lithiumplating zu detektieren ist daher abhängig von der Häufigkeit bzw. Regelmäßigkeit der Anwendung dieser Methodik.

Die WO2022032460A1 offenbart ein Verfahren zum Detektieren von Lithiumplating während des Betriebs einer Batterie. Dies geschieht mit Hilfe von Drucksensoren und Informationen, welche über die elektrischen Eigenschaften der LIB, gewonnen werden können. Auch bei dieser Lehre muss der Energiespeicher davor charakterisiert werden.

Ebenso basiert die WO2022109539A1 auf dem elektrischen Verhalten der LIB, was mit den soeben geschilderten Nachteilen behaftet ist.

In der Veröffentlichung C. Bommier et al., "In Operando Acoustic Detection of Lithium Metal Plating in Commercial LiCoO2/Graphite Pouch Cells", Cell Rep. Phys. Sci., Bd. 1, Nr. 4, Art. Nr. 4, Apr. 2020, doi: 10.1016/j.xcrp.2020.100035, werden im Rahmen eines Verfahrens Ultraschallmessungen an LIB durchgeführt, bei welchen die Piezoelemente auf den exakt gegenüberliegenden Seiten des LIB-Körpers platziert werden. Dieser Versuchsaufbau wird in der Literatur auch als "through body measurements" bezeichnet. Ein Piezoelement dient als Sender und regt eine mechanische Welle an, welche sich von der Oberseite in Dickenrichtung zur Unterseite der LIB ausbreitet und anschließend vom Empfangselement in ein elektrisches Signal umgewandelt wird. Aufgrund dessen, dass LIB in der Regel nur eine Dicke von wenigen Millimetern haben, muss ein Anregesignal mit einer sehr geringen Wellenlänge verwendet werden, um somit die LIB in Schwingung zu versetzen. Um dies zu erreichen, wurde eine Frequenz von 2.25 MHz gewählt. Diese Messanordnung und die um Faktor 200-300 größeren Anregefrequenz ist der wesentliche Unterschied zwischen der veröffentlichten Arbeit und der im folgenden vorgestellten Methode. Um Signale bei dieser hohen Frequenz auswerten zu können, bedarf es sehr präzisen Messinstrumenten und spezieller Elektronik, welche dementsprechend den Kostenfaktor im Anwendungsfall in nachteiliger Weise drastisch erhöht. Ein weiterer Nachteil ist die Methodik, anhand welcher Lithiumplating detektiert wird. Die Autoren der Publikation verwenden eine dafür erforderliche getätigte und vorliegende Referenzmessung, um diesen chemischen Prozess zu detektieren.

Aufgabe der Erfindung ist es, die Nachteile des Standes der Technik zu überwinden und ein Verfahren anzugeben, auf möglichst einfache Weise den physischen Zustand einer Batterie während des Betriebs eingriffs- und zerstörungsfrei hinsichtlich möglicher nicht gewünschter Veränderungs- und Alterungsprozesse, die Auf- und Entladezyklen an Batterien während der Betriebszeiten verursachen, zu messen. Das Verfahren soll genau, zuverlässig, sicher, kostengünstig hinsichtlich eingesetzter Apparate und wartungsarm sein.

Das erfindungsgemäße Verfahren erreicht die Ziele bei einer Batterie, wobei die Batterie eine Lithium-Ionen Batterie ist und eine Außenseite aufweist, wobei mechanische Wellen im Frequenzbereich von etwa 5 kHz bis etwa 100 kHz mittels mindestens eines Emitters, der auf der Außenseite der Batterie aufgebracht ist, ausgesendet und die Wellen anschließend von mindestens einem ersten Empfänger, der in einem vorbestimmten Abstand vom Emitter auf der Außenseite der Batterie aufgebracht ist, empfangen werden, umfassend die weiteren Schritte:
Zuführen der empfangenen Wellen einer Auswerteeinrichtung,
Auswerten der empfangenen Wellen hinsichtlich ihrer Ausbreitungsgeschwindigkeit und/oder ihrer Time of Flight (TOF) zwischen Emitter und Empfänger,
Auswerten der empfangenen Wellen hinsichtlich ihrer Signalamplituden,
sowie
Errechnen des Zeitpunkts des Anfanges und/oder das Stadium von Lithiumplating der Batterie auf der Basis dieser Auswertungen.

Es ist ebenso vorgesehen, dass die Batterie eine Lithium-Ionen-Batterie ist und wobei der errechnete Zustand der Zeitpunkt des Anfanges und/oder das Stadium von Lithiumplating ist, um das Verfahren auf einen verbreiteten Akkumulatorentyp und seine verbreitete Alterserscheinung anzuwenden.

Bei einer Ausführungsform der Erfindung liegen die gesendeten Wellen im Frequenzbereich von etwa 5 kHz bis etwa 100 kHz, da dadurch sowohl weiterhin die physischen Zustände ermittelbar bleiben, jedoch kostengünstige elektronische Bauteile zur Durchführung des Verfahrens nutzbar sind.

Bei einer weiteren Ausführungsform der Erfindung ist ein zweiter Empfänger auf einer gegenüberliegenden Seite zur Seite des ersten Empfängers auf der Außenseite der Batterie, vorzugsweise lotrecht dem ersten Empfänger gegenüberliegend, aufgebracht, wobei der zweite Empfänger vorab zur Findung eines geeigneten Signals zu derselben Zeit wie der erste Empfänger Wellen von mehreren Anregesignalen empfängt und der Auswerteeinrichtung zuführt. Dadurch werden zusätzlich Messwerte für eine bessere Kalibrierung des Systems ermittelt.

Es ist ebenso vorteilhaft, dass die Auswertung der empfangenen Wellen hinsichtlich der Moden von Lambwellen erfolgt, da weitere Parameter zu den physischen Zuständen der Batterie ermittelbar sind.

Es kann ebenso vorgesehen sein, dass der Emitter einen Puls von Wellen aussendet, der vorzugsweise in Form einer Einhüllenden moduliert ist, um störende harmonische Schwingungen nicht zu erzeugen.

Bei einer Ausführungsform der Erfindung ist der ausgesendete Puls von Wellen etwa drei bis etwa acht, vorzugsweise etwa fünf Perioden lang, wodurch die Messung präziser wird.

Es können ebenso die weiteren Schritte vorgesehen sein:
Speichern der Resultate zeitlich aufeinanderfolgender Messungen, insbesondere von Amplitude und/oder Ausbreitungsgeschwindigkeit, sowie
Errechnen eines physischen Parameters aus dem zeitlichen Verlauf der Resultate. Dadurch lassen sich Ableitung von zeitlich verändernden Messwerten aufstellen, aus denen weitere Informationen gewinnbar sind.

In einer abermals weiteren Ausführungsform wird vor der Errechnung des physischen Zustands eine Eichmessung durchgeführt, deren Ergebnis in der Auswerteeinrichtung gespeichert wird. Dadurch können Bautyp-spezifische oder gänzlich individuelle Messbedingungen an einer Batterie herausgerechnet werden.

Es ist auch denkbar, dass die Batterie ein Batterie-Managementsystem (BMS) sowie eine elektronische Messeinrichtung aufweist, wobei die elektronische Messeinrichtung den Emitter, den ersten und ggf. den zweiten vorhandenen Empfänger steuert, wobei ferner die elektronische Messeinrichtung die Auswerteeinrichtung umfasst, in der die Auswertungsschritte erfolgen. Diese Maßnahme führt zu einer seriellen Herstellbarkeit der Rahmenbedingungen, das Verfahren an einer seriell gefertigten Batterie durchzuführen. Zudem nutzt es eine oftmals schon vorhandene Infrastruktur an einer Batterie.

Alternativ teilt die elektronische Messeinrichtung dem BMS Messergebnisse mit, was bedeutet, dass die elektronische Messeinrichtung ein Bestandteil des BMS ist, wodurch das BMS um die Funktionen der elektronischen Messeinrichtung erweitert wird.

Alternativ werden die von der elektronischen Messeinrichtung gesteuerten Signale an den Emitter und/oder die empfangenen Signale des oder der Empfänger vor der Auswertung elektrisch verstärkt. Dadurch kann die Messelektronik klein und leistungsschwach ausgeführt sein, während dennoch genaue Messungen durchführbar bleiben.

In einer weiteren Ausführungsform löst das BMS der Batterie auf der Basis des errechneten Zustandes der Batterie einen Aufladevorgang, einen Entladevorgang, eine Heizaktion, eine Signalabgabe und/oder eine Abschaltung aus. Dadurch kann die Betriebsart einer Batterie so angepasst werden, dass ein ungewünschter physischer Veränderungszustand nicht, später oder schwächer eintritt.

Es ist auch denkbar, dass die Batterie im wesentlichen quaderförmig ausgebildet ist sowie eine Ober- und eine Unterseite aufweist, wobei der Emitter auf der Oberseite und der erste Empfänger auf der Oberseite oder der Unterseite der Batterie aufgebracht ist. Das Verfahren kann somit auf dem gängigsten geometrischen Körper für Batterien ausgeführt werden und lässt Spielraum für die konkrete Anordnung des Emitters und des oder der Empfänger.

Alternativ ist die Batterie im wesentlichen zylindrisch ausgebildet, deren Außenseite, auf welcher der Emitter, der erste Empfänger und ggf. der zweite Empfänger angeordnet sind, durch die Mantelfläche gebildet wird. Dadurch lässt sich das Verfahren auf einem zweiten gängigen geometrischen Körper für Batterien ausführen.

Es lässt sich festhalten, dass der entscheidende Vorteil des Verfahrens darin liegt, unabhängig von den Messwerten der elektrischen Eigenschaften bzw. des elektrischen Zustands (Zellspannung etc.) der LIB und ohne vorhergehende Charakterisierung des Energiespeichers den Startzeitpunkt des Lithiumplatings exakt zu bestimmen. Als entscheidende Parameter werden die ermittelte Ausbreitungsgeschwindigkeit und die Signalamplitude und dessen Änderungsraten herangezogen. Diese sind unabhängig von der Messung der elektrischen Werte und dementsprechend ein sicherer und zuverlässiger Indikator, um diesen unerwünschten chemischen Prozess in seiner Entstehung zu detektieren und in weiterer Folge ein Fortschreiten dieses durch geeignete Gegenmaßnahmen zu verhindern. Es kann der Messaufbau so umgesetzt werden, dass verhältnismäßig geringe Frequenzen zur Anregung der Piezoelemente verwendet werden können, weshalb der Einsatz von kostengünstiger Elektronik möglich ist. Dies macht die Verwendung dieser Methode für Anwendungen, welche als Aufgabe die Überwachung von
Energiespeichern haben, äußerst attraktiv.

Weitere Vorteile und Ausführungsformen der Erfindung ergeben sich aus der Beschreibung und den Zeichnungen. Die Erfindung wird nachstehend anhand eines in den Zeichnungen dargestellten Ausführungsbeispiels näher erläutert. Es zeigen: Fig. 1 einen schematischen Messaufbau, Fig. 2 eine Veranschaulichung von Lambwellen, Fig. 3 ein Zeit-Amplitudendiagramm von gesendeten und empfangenen Pulsen, Fig. 4, Fig. 5A und Fig. 5B jeweils ein Diagramm von Gruppengeschwindigkeiten und Ladungszustand, Fig. 6A und Fig. 6B Diagramme von der Amplitude bei Entladevorgängen, Fig. 7A und 7B Diagramme der zeitlichen Ableitung der Gruppengeschwindigkeit bei Entladevorgängen und Fig. 8A und Fig. 8B Diagramme der zeitlichen Ableitung der Amplitude bei Entladevorgängen

Das Verfahren ist ein zerstörungsfreies, welches während des Betriebs von Batterien 1 im allgemeinen und Lithium-Ionen-Batterien (LIB) im Besonderen eingesetzt werden kann. Dabei werden Piezoelemente als Emitter T1 sowie als Empfänger T2, T3 an der Oberfläche der Lithium-Ionen Pouch Zelle platziert und durch eine gezielte elektrische Anregung eines Piezoelements eine so genannte Lambwelle generiert, welche sich in der LIB ausbreitet. Die Ausführungsform der genannten Bauteile als Piezoelemente ist eine kostengünstige und sichere Alternative zu anderen Emittern und Empfängern mechanischer Wellen in dem hier genannten Frequenzbereich, die gleichermaßen möglich wären. Bei den Wellenmessungen werden Ultraschallwellen, aber auch Wellen in einem Frequenzbereich <20 kHz erzeugt, um die Piezoelemente anregen zu können. Es wird daher allgemein von mechanischen Wellen gesprochen.

Durch die Verformung der LIB, die aufgrund der sich ausbreitenden Welle stattfindet, verformt sich auch das als Empfänger T2, T3 definierte Piezoelement, welches durch den direkten piezoelektrischen Effekt eine elektrische Spannung generiert. Diese kann gemessen und mit dem Anregungssignal verglichen werden. Daraus können Rückschlüsse auf die mechanischen Eigenschaftsänderungen und den Zustand der LIB getroffen werden. Durch diese Messung, welche nicht auf den Messwerten der elektrischen Eigenschaften bzw. des elektrischen Zustandes (Zellspannung etc.) basiert, können genauere Aussage über den SOC der LIB getroffen werden. Mit dem im Folgenden beschriebenen technischen Konzept bzw. mit diesem Verfahren, ist es möglich neben dem SOC auch den gesamten chemischen Prozess z.B. des Lithiumplatings festzustellen. Vor allem lässt sich dadurch der genauen Startzeitpunkt dieses sicherheitskritischen Prozesses detektieren.

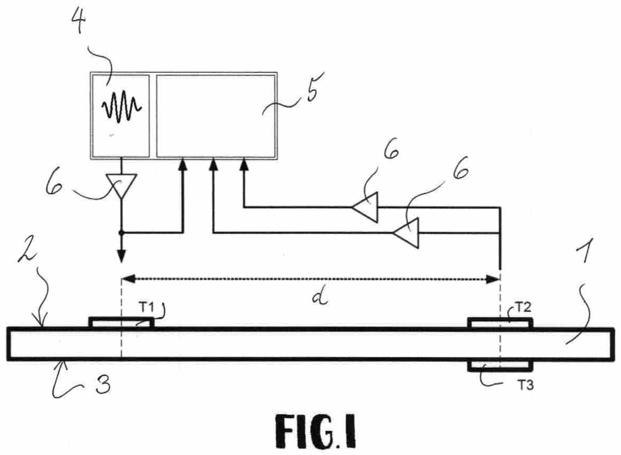

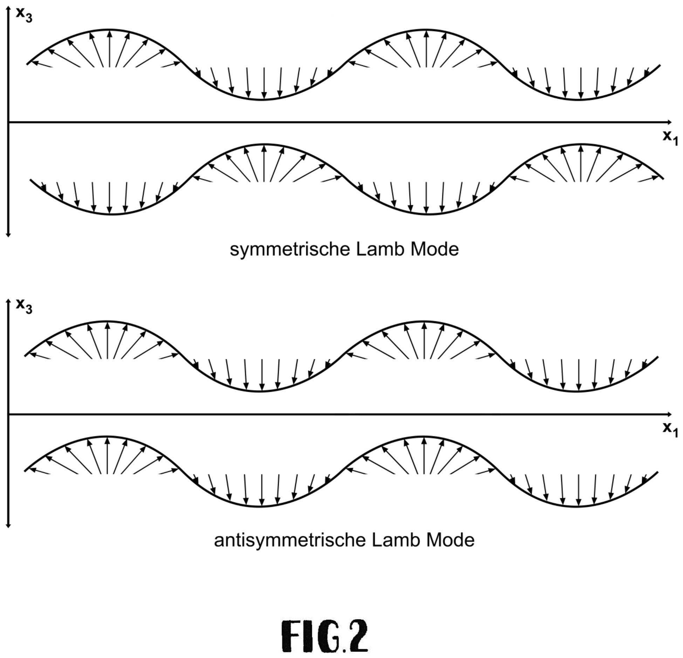

**In** Fig. 1 ist der Aufbau bzw. die Vorrichtung zu sehen, welcher für die Detektion von Lithium-plating verwendet wird. Das Verfahren kann an jedem quaderförmigen oder plattenförmigen Batteriekörper mit einer Außenseite ausgeführt werden. Fig. 1 zeigt das Beispiel einer quaderförmigen Batterie 1. Bei dem Aufbau werden zwei Piezoelemente mit einem definierten Abstand d an der Oberfläche bzw. Außenseite, und zwar an der dafür definierten Oberseite 2 der LIB platziert, wobei eines als das mindestens eine Sendeelement bzw. der mindestens eine Emitter T1 und das andere als Empfangselement bzw. Empfänger T2 dient, welcher ebenso zumindest einmal vorliegt. An der Unterseite 3 der LIB, auf der exakt gegenüberliegenden Seite des ersten Empfangselements, also lotrecht darunter, wird ein weiteres Piezoelement platziert, welches als zweiter Empfänger T3 dient. Aufgrund dieser Anordnung ist es möglich, die sich ausbreitenden Lambwellen-Moden zu unterscheiden und dementsprechend gezielt eine gewünschte Mode zu detektieren, um somit ein genaueres Verständnis der sich ändernden mechanischen Eigenschaften zu detektieren. Lambwellen sind gemäß Fig. 2 dispersive Wellen und ändern abhängig von der Dicke des zu untersuchenden Objektes und der Frequenz die Ausbreitungsgeschwindigkeit. Zusätzlich gibt es eine beliebige Anzahl an Moden und abhängig von dem Frequenz-Dicken-Produkt und des zu untersuchenden Körpers variiert die Anzahl der auftretenden Moden. Diese können unterteilt werden in symmetrische und antisymmetrische Moden und die Verschiebungsvektorfelder dieser beiden sind in Fig. 2 zu sehen.

Hier sieht man in allgemeinen Raumkoordinaten (x₁, x₂, x₃), dass die Verschiebungsvektoren für die antisymmetrischen Mode in dieselbe Richtung entlang der Ober- und Unterseite der Platte zeigen. Im Vergleich dazu, ist bei der symmetrischen Mode, die Verschiebung an jedem Punkt der jeweiligen Oberfläche in die entgegengesetzte Richtung gerichtet. Durch die Platzierung von zwei sich exakt gegenüberbefindenden Empfangspiezoelementen ist es möglich, zwischen der symmetrischen und antisymmetrischen Mode zu unterscheiden.

Der wesentliche Vorteil dieser Anordnung ist es, die verschiedensten Moden unterscheiden zu können, um dadurch die bestmöglichen Parameter für die Frequenz und die Amplitude eines Anregungssignals zu finden. Ein gut gewähltes Signal vereinfacht drastisch den Arbeitsaufwand für die Datenanalyse.

Für die Detektion von Lithiumplating ist es hinreichend, einen Versuchsaufbau mit zwei Piezoelementen (Sender und Empfänger) zu verwenden. Zusätzlich muss das Empfangspiezoelement (Empfänger T2) nicht zwingend auf derselben Seite der Batterie befestig sein, sondern kann sich auch auf der gegenüberliegende Seite in einem gewissen Abstand zum Sende-Piezoelement (Emitter T1) befinden, z.B. am Ort des Empfängers T3 in Fig. 1. Ein zweites Empfangselement, welches auf der gegenüberliegenden Seite orthogonal zum ersten Empfangselement angebracht ist, (vgl. zweiter Empfänger T3 zu erstem Empfänger T2 in Fig. 1), dient vor allem für die Bestimmung eines geeigneten Anregesignals, welches aus Signalen, die sich hinsichtlich Frequenz, Einhüllender, Anzahl der Schwingungsperioden etc. untereinander unterscheiden, vorab ausgewählt wird. Dieser Vorgang kann einmalig vorab geschehen oder regelmäßig. Er kann z.B. für ein Batteriemodell einmalig manuell ausgeführt werden oder automatisiert durch einen Programmablauf auf einer elektronischen Messeinrichtung, die Emitter T1 und Empfänger T2, T3 steuert.

Die Messung wird anhand des zweiten Empfängers T3 nicht genauer, da die Änderung der Geschwindigkeit und der Amplitude sowohl mit dem ersten als auch mit dem zweiten Empfänger gemessen werden können. Dementsprechend kann der Prozess des Lithiumplatings auch mit einem Empfänger auf der gegenüberliegenden Seite des Sende-Piezoelements festgestellt werden.

Mit einem zweiten Empfänger T3 kann man neben der Signalfindung auch zwischen den einzelnen Moden der empfangenen Wellen unterscheiden und dementsprechend bessere Rückschlüsse auf die mechanischen Eigenschaftsänderungen der Batterie 1 ziehen. Bestimmungen von Materialparametern wie E-Modul, Dicke etc., welche z.B. für Simulationen genutzt werden können, sind ebenso durch Auswerten von Messwerten eines zweiten Empfängers T3 möglich. Wie bereits zuvor erwähnt können damit auch die mechanischen Eigenschaftsänderungen durch die Modendetektion genau festgestellt werden.

Es spielen bei den Wellenmessungen vor allem zwei Messparameter eine wesentliche Rolle. Dies ist einerseits die Amplitude des empfangenen Signals und andererseits die Ausbreitungsgeschwindigkeit der Welle. Letztere wird über die Distanz der beiden Piezoelemente zueinander und der Dauer (Time of Flight - TOF), welche die Welle bzw. in weiterer Folge das Signal benötigt, um vom Senderelement zum Empfangselement zu propagieren, berechnet. Es gibt mehrere Arten, wie die TOF bzw. die Ausbreitungsgeschwindigkeit berechnet werden kann. Zum besseren Verständnis wird im Anschluss die verwendete Methode beschrieben. Diese kann jedoch auch durch andere Berechnungsverfahren substituiert werden.

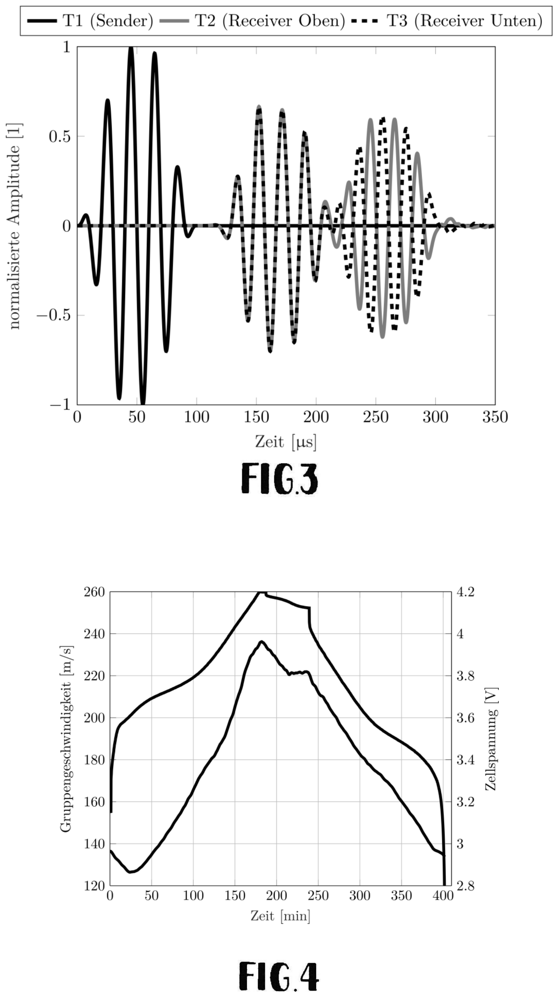

Um ein Piezoelement in Schwingung zu versetzen, ist es notwendig, eine Spannungsänderung anzulegen, was oftmals in der Praxis eine Spannung mit wechselnden Vorzeichen ist. Dies ist das wesentliche Kriterium für die Auswahl eines geeigneten Signals für die Anregung. **In** dem hier beschriebenen Fall wird eine modulierte Sinusschwingung von fünf Perioden bei einer vorbestimmten Frequenz verwendet. Aufgrund dieses schmalbandigen Erregersignals, können gezielt Frequenzen angeregt werden. Das Errechnen des gesuchten quantitativen Zustandes der Batterie erfolgt also auf Bereitstellung eines Modells, in das Messwerte einfließen und ein Wert, der mit dem quantitativen Zustand, z.B. Stadium des Lithiumplatings, identifiziert wird, errechnet wird. Ein Beispiel zeigt Fig. 3. Es sind das Anregungssignal (schwarz, durchgehen, beginnend bei t=0) und die empfangenen Signale der beiden Piezoelemente zu sehen (gestrichelt sowie grau). Hier ist auch die symmetrische und antisymmetrische Lambwellenmode zu erkennen, welche anhand des empfangenen Signals des an der Unterseite befestigten Piezoelements unterschieden werden kann. Diese Abbildung stammt von einem Simulationsergebnis an Akrylglas.

Um die TOF zu bestimmen, wird zunächst die Einhüllende des gesendeten und empfangen Signals gebildet. Der Maximalwert der im Anschluss durchgeführten Kreuzkorrelation, bei welcher die beiden Einhüllenden als Input verwendet wurden, liefert die zeitliche Verschiebung der beiden Signale. Durch die bekannte Distanz der beiden Piezoelemente und der berechneten Zeitdifferenz ist es möglich, die Ausbreitungsgeschwindigkeit der Welle zu bestimmen. Dabei handelt es sich um die sogenannte Gruppengeschwindigkeit und nicht um die Phasengeschwindigkeit, da die Einhüllende des gesamten Wellenpakets gebildet wurde.

Die Einhüllende kann verschiedene Formen aufweisen: gaußförmig, Glocke, eine halbe Sinusperiode etc. Eine Einhüllende wird deshalb verwendet, da bei einer pulsartigen Anregung, wie z.B. einem Rechteckpuls, harmonische Schwingungen auftreten. Dies würde dazu führen, dass das Piezoelement nicht mehr mit der gewünschten Frequenz schwingt, sondern verschiedenste unerwünschte Frequenzen angeregt werden (Fast Fourier Transformation (FFT) von einem Rechteckpuls bei einer beliebigen Frequenz veranschaulicht das). Wären im vorliegenden Fall die 5 Sinuspulse nicht moduliert, so würde sich der erste Sinuspuls ähnlich wie ein Rechteckpuls auf das Piezoelement auswirken. Durch die Modulation bzw. die langsame Erhöhung der Amplitude bzw. Verminderung der Amplitude, wird die Anregung der harmonischen Frequenzen minimiert, so dass man davon ausgehen kann, dass das Piezoelement größtenteils nur mit der gewählten Frequenz schwingt.

Die Gruppengeschwindigkeit ändert sich bereits während eines Lade- bzw. Entladevorgangs wie in Fig. 4 zu sehen ist. Es ist die Gruppengeschwindigkeit (untere Kurve) und die Zellspannung während eines Lade- und Entladevorgangs einer LIB (obere Kurve), gemessen bei einem Anregesignal von 14 kHz dargestellt. Bei drastischeren mechanischen Eigenschaftsänderungen einer LIB, welche unter anderem durch chemische Prozesse wie Lithiumplating entstehen, ändert sich die Gruppengeschwindigkeit innerhalb eines kürzeren Zeitraums wesentlich stärker als bei einem normalen Lade- bzw. Entladevorgangs Das Identifizieren dieser sicherheitskritischen chemischen Prozesse anhand von Messungen der mechanischen Wellen und die zugrunde liegende Methodik wird im Folgenden behandelt.

Die Erfindung ist eine kostengünstige und einfach umsetzbare Methodik, mit welcher es anhand von Wellenmessungen an Energiespeichern möglich ist, den chemischen Prozess des Lithiumplatings und dessen Startzeitpunkt während des Betriebs zu erkennen. Dies erfolgt durch die Analyse der Gruppengeschwindigkeit und der Signalamplituden, welche aus den Messdaten gewonnen werden. Anhand signifikanter Änderungen dieser Parameter, ist es möglich diesen chemischen Prozess während der Entstehung zu erkennen und ein weiteres Fortschreiten, welches zu einem sicherheitskritischen Ereignis führen kann, zu verhindern.

Wie bereits zuvor beschrieben, berechnet sich die Gruppengeschwindigkeit aus der gemessenen TOF und dem Abstand des Emitter- und des Empfängerpiezoelements. Letzteres ist ein konstanter Wert bzw. Faktor für den jeweiligen Messaufbau, weshalb die Messresultate von TOF und Gruppengeschwindigkeit direkt ineinander umrechenbar sind und daher die Detektion von Lithiumplating ebenfalls anhand der ermittelten TOF durchgeführt werden kann.

Durch die Verwendung von niedrigen Frequenzen zur Generierung des Anregesignals, ist es möglich diese Methodik kostengünstig und einfach in ein Batterie-Managementsystem (BMS) zu integrieren bzw. ein BMS mit einer das Verfahren ausführenden Messeinrichtung zu erweitern, um somit eine kontinuierliche Überwachung des Energiespeichers anhand der durch die Wellenmessung ermittelten Werte durchzuführen. Überschreiten die Messwerte vorbestimmte Grenzen, können dadurch die Betriebsparameter des elektrischen Speichers, wie zum Beispiel der Ladestrom oder die Temperatur sofort angepasst werden. Dadurch kann der Prozess des Lithiumplatings einerseits erkannt und andererseits bereits in der Phase der Entstehung verhindert werden, wodurch ein sicherer Betrieb des Energiespeichers gewährleistet werden kann.

Da die Elektronik für die Anregungssignale nicht standardmäßig in einem BMS vorhanden ist, ist ein vorhandenes BMS zu erweitern. Diese Erweiterung kann einerseits in das BMS integriert werden, andererseits kann auch eine zusätzliche Platine/Elektronik entworfen werden, welche mit dem BMS kommuniziert.

In einer weiteren Ausführungsform löst das BMS der Batterie auf der Basis der vorgestellten Methodik eine Aktion aus. Diese kann abhängig von dem ermittelten Zustand eine Anpassung des Ladeverfahrens wie zum Beispiel der Adaption der Stromrate, den Stopp eines Lade-Entladevorgangs oder das Einleiten eines Lade- Entladevorgangs darstellen. Falls die Anwendung mit einem Thermomanagement ausgerüstet ist, welches vom BMS gesteuert wird, können auch hier Aktionen wie zum Beispiel der Einleitung eines Heizvorgangs, eines Kühlvorgangs oder den Stopp des Thermomanagements ausgeführt werden. In vielen Anwendungen kommuniziert das BMS auch mit einer für den Anwender ersichtlichen Schnittstelle, wodurch Informationen über den aktuellen Zustand (Ladezustand etc.) dem Benutzer bekanntgegeben werden. Wird das Auftreten von Lithiumplating detektiert so, kann dies auch dem Benutzer mittels dem BMS über die Schnittstelle mitgeteilt werden. Dadurch wird ein sicherheitskritischer Zustand, welcher durch Lithiumplating entstehen kann, detektiert und ein kritisches Voranschreiten dieses Prozesses kann verhindert werden.

Der für die Anwendung zugrunde liegende Messaufbau besteht aus mindestens zwei Piezoelementen, welche auf der Außenseite einer LIB angebracht werden. Ein Piezoelement dient als das mindestens eine Sendeelement (Emitter T1) wohingegen mindestens ein weiteres Piezoelement als Empfangselement (Empfänger T2, T3) dient. Die Elemente werden dabei formschlüssig, kraftschlüssig oder stoffschlüssig in einem vorbestimmten Abstand d zueinander an der Oberfläche der als Energiespeicher dienenden Batterie 1 platziert. Der Abstand wird dabei so gewählt, dass die Spannungsamplitude, welche durch die mechanische Verformung des Empfangspiezoelements entsteht, hinreichend groß ist, um diese in weiterer Folge mathematisch analysieren zu können. Werden Verstärker für das Sendesignal und/oder das Empfangssignal eingesetzt, werden zudem größere Abstände ermöglicht, so dass das Verfahren auf alle gängige Batteriekörpergrößen angewendet werden kann.

Als elektrisches Anregungssignal wird eine Spannung, welche als Puls, Schwingung oder modulierte Schwingung ausgeführt werden kann, verwendet. Aufgrund des beschriebenen Messaufbaus ist es möglich, Anregefrequenzen, welche kleiner als 100 kHz sind, zu verwenden. In Hinblick für die dafür benötigte Elektronik führt dies zu einer einfachen und kostengünstigen Umsetzung dieses Verfahrens. In den später angeführten Beispielmessungen wird eine Frequenz von nur 14 kHz für die Anregung des Piezoelements verwendet. Dies verdeutlicht die simple und kostengünstige Möglichkeit einer Implementation in bereits bestehende elektronische Systeme, welche zur Überwachung bzw. zur Bestimmung des aktuellen Zustands von Energiespeicher verwendet werden.

In Fig. 1 ist eine Variante eines Messaufbaus zur Durchführung des Verfahrens dargestellt. Dabei wird ein Frequenzgenerator 4 für die Erzeugung des Anregesignals und ein Oszilloskop 5 zum Aufnehmen des empfangenen Signals bzw. der empfangenen Signale verwendet. Diese beiden elektronischen Einrichtungen können durch andere, wie zum Beispiel durch ein Batteriemangementsystem (BMS), welches die Funktionen zum Generieren und Erfassen von Signalformen besitzt, ersetzt werden. Besteht der Fall, dass die Amplituden der Signale für die darauffolgende Analyse nicht hinreichend groß ausgebildet sind und sich dies auch nicht durch eine Verminderung des Abstandes der beiden notwendigen Emitter T1 und ersten Empfänger T2 zueinander ändern lässt, können Verstärker 6 eingesetzt werden.

Aus den gemessenen und gesendeten Signalen, wie in Fig. 3 ersichtlich, kann die zeitliche Differenz der Signale (TOF) ermittelt werden. Durch den gewählten Abstand der befestigten Piezoelemente lässt sich auch die Geschwindigkeit der sich ausbreitenden Welle bestimmen. Es gibt verschiedene Möglichkeiten diese sogenannte Gruppengeschwindigkeit, der sich ausbreitenden Wellenpakete zu bestimmen. Diese sind dem Fachmann bekannt. Für die Bestimmung der Amplitude des empfangen Signals können ebenfalls verschiedene Methoden angewendet werden. Diese können unter anderem über die maximale Spannung der Einhüllenden oder einzelner Peaks des Wellenpaketes bestimmt werden.

Unerwünschte bzw. sicherheitskritische chemische Prozesse von Energiespeichern, wie zum Beispiel Lithiumplating, entstehen vor allem dann, wenn die vom Hersteller angegebenen Betriebsparameter nicht eingehalten werden. Diese können aber auch durch Produktionsfehler oder durch eine falsche Handhabung verursacht werden. Im nachfolgenden Abschnitt sind Messergebnisse zu sehen, bei welchen die Temperatur, eine der vorgeschriebenen Betriebsparameter, so verändert wurde, dass der chemische Prozess des Lithiumplatings auftritt. Dabei wurde eine LIB in einem Klimaschrank bei zwei unterschiedlichen Temperaturen zyklisiert und mittels der beschriebenen Methodik, wurde die Gruppengeschwindigkeit und die Amplitude des empfangenen Signals analysiert.

An dieser Stelle ist anzumerken, dass nicht nur eine niedrige Temperatur der Verursacher von unerwünschten chemischen Prozessen eines Energiespeichers ist. Vielmehr ist es ein Zusammenspiel von diversen Parametern, wie dem Ladestrom, dem Spannungsfenster, in dem der Energiespeicher betrieben wird, dem Gesundheitszustand und auch der vorangegangenen Handhabung des Speichers. Selbst wenn man jeden dieser einzelnen Parameter kennt und auch Informationen über den elektrischen Zustand der Batterie hat, ist es dennoch äußerst schwierig unerwünschte chemische Prozesse, wie zum Beispiel Lithiumplating während des Betriebs korrekt zu identifizieren. Die im Folgenden gezeigten Ergebnisse der Analyse der Gruppengeschwindigkeit und der Amplitude von Wellenmessungen, sollen zeigen, dass es mit der hier beschriebenen Methodik möglich ist, unabhängig von den zuvor genannten Parametern, sofort unerwünschte Prozesse, wie z.B.Lithiumplating, feststellen zu können.

Während der Stand der Technik einzig auf den Messwerten der elektrischen Eigenschaften bzw. des elektrischen Zustandes der **LIB** basiert, ist das Verfahren unabhängig von diesem, da Lithiumplating anhand von structural health monitoring (SHM) festgestellt wird. Während zudem im Stand der Technik eine Referenzmessung verwendet wird, um diesen chemischen Prozess zu detektieren, muss im Verfahren keine Messung als Referenz herangezogen werden. Dementsprechend ist es nicht zwingend notwendig, eine vorhergehende Charakterisierung des Energiespeichers durchzuführen. Das Verfahren wird jedoch genauer und zuverlässiger, wenn man das exakte Verhalten der Batterie unter verschiedenen Bedingungen kennt. Wenn man z.B. einbezieht, wie sich die Ultraschallsignale bei 20 °C und bei einer gewissen Stromrate verhalten als vorab gespeicherten Vergleichswert heranzieht, dann kann man auch unerwünschte Prozesse wie Lithiumplating detektieren.

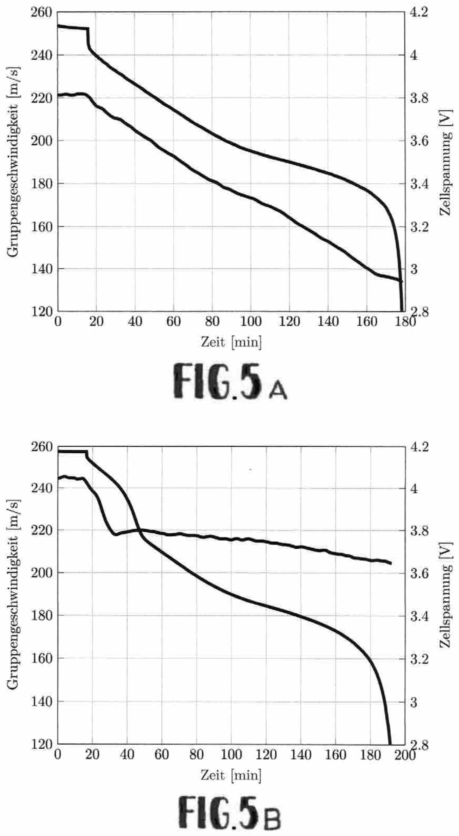

**In** Fig. 5A und Fig. 5B sind die Gruppengeschwindigkeiten während eines Entladevorganges bei Raumtemperatur (Fig. 5A) und bei einer Temperatur von 10°C (Fig. 5B) gegenübergestellt. Die bei t=0 obenliegenden Graphen stellen die Zellspannung dar, die darunterliegenden Graphen die Gruppengeschwindigkeiten.

Bei Raumtemperatur (Fig. 5A) nimmt die Gruppengeschwindigkeit während des gesamten Entladevorgangs annähernd linear ab. Vereinzelt finden sich Änderungen in der Steigung, jedoch sind diese minimal ausgeprägt. Die Gruppengeschwindigkeit hat im vollgeladenen Zustand einen Wert von ca. 220 m·s-1 und im entladenen Zustand einen Wert von ca. 135 m·s-1, was einer Änderung von ungefähr 85 m·s-1 bzw. 39 % entspricht.

Durch eine Änderung der Umgebungstemperatur verändert sich auch die Gruppengeschwindigkeit. Dies ist zurückzuführen auf die Temperaturabhängigkeit der mechanischen Eigenschaften des Energiespeichers und bewirkt, dass sich auch die Ausbreitungsgeschwindigkeit der von den Piezoelementen angeregten Lambwelle ändert. Der Effekt der temperaturabhängigen Ausbreitungsgeschwindigkeit wurde bereits in diversen Publikationen in der Literatur beobachtet.

Wie in Fig. 5B ersichtlich, hat die Gruppengeschwindigkeit der vollgeladenen **LIB** bei einer Umgebungstemperatur von 10°C dementsprechend einen höheren Wert als bei Raumtemperatur (250 m·s-1 gegenüber 220 m·s-1). Jedoch verhält sich die Gruppengeschwindigkeit nicht annähernd linear. Bei einer Zellspannung von ca. 4.1 V ändert sich der Verlauf drastisch. Die Gruppengeschwindigkeit verringert sich innerhalb kürzester Zeit bzw. innerhalb von äußerst geringen Zellspannungsunterschieden von ca. 245 m·s-1 auf 215 m·s-1, was einer Änderung von ca. 30 m·s-1 bzw. 12 % entspricht. Während des weiter stattfindenden Entladevorgangs, sinkt die Gruppengeschwindigkeit weniger stark als bei der Messung bei Raumtemperatur.

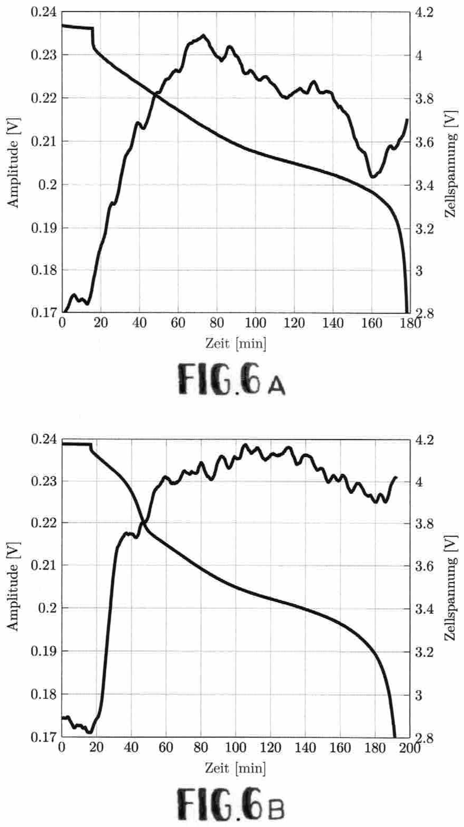

Ein ähnliches Phänomen ist auch bei der Amplitude des empfangenen Signals zu erkennen. **In** Fig. 6 A und B sind die gemessenen Maxima der Einhüllenden des Signals während desselben Entladevorgangs zu sehen. Bei t=0 sind die jeweils obenliegenden Graphen die Zellspannung, und die darunterliegenden, mit der Zeit ansteigenden Graphen die Amplitude. Bei Raumtemperatur (Fig. 6A) steigt die Amplitude zunächst, wohingegen diese gegen Ende des Ladevorgangs leicht sinkt. Bei einer Temperatur von 10°C (Fig. 6B) ändert sich der Verlauf drastisch. Die Amplitude steigt bei ca. 4.1 V innerhalb von kürzester Zeit um ca. 31 %. Betrachtet man sowohl Fig. 5B und 6B, erkennt man, dass bei der Gruppengeschwindigkeit und der Amplitude bei der gleichen Zellspannung drastische Änderungen stattfinden. Dies ist ein eindeutiges Indiz dafür, dass zu diesem Zeitpunkt während des Entladevorgangs gravierende mechanische Eigenschaftsänderungen stattgefunden haben, welche auf einen internen chemischen Prozess rückzuführen sind.

Bis jetzt zeigen die Ergebnisse drastische Änderungen der Gruppengeschwindigkeiten und Amplitude bei niedrigen Temperaturen. Zusätzlich weist die **LIB** während weiterer Lade- und Entladezyklen einen Kapazitätsverlust auf. Um den Grund dieser beiden ungewöhnlichen Verhalten nachzugehen, wurde die **LIB** im Rahmen einer Post-Mortem-Analyse in einer Glovebox unter einer Argon-Atmosphäre geöffnet. Die einzelnen Kathoden und Anoden Schichten wurden dabei zunächst visuell untersucht. Die Anode, welche sich an der Oberseite des Elektrodenstapels befand, hatte keine Gegenelektrode (Kathode), weshalb bei dieser kein Potentialunterschied vorlag und dementsprechend keine Interkalationsprozesse stattgefunden haben. Diese kann daher als Referenzanode betrachtet werden. Es wurde auch eine Anode untersucht, welche aus der Mitte des Elektrodenstapels entnommen wurde und deshalb den elektrischen und chemischen Prozessen während der Lade- bzw. Entladevorgänge ausgesetzt war. Es war deutlich zu erkennen, dass sich diese beiden Anoden drastisch unterscheiden. Es haben sich Ablagerungen an der Oberfläche, der aus der Mitte entnommen Elektrode gebildet. Eine klare bräunliche Verfärbung ist ein Indiz dafür, dass es sich hierbei um Lithiummetall handelt, welches sich bei dem chemischen Prozess des Lithiumplatings an dem Grafit der Anode ablagert. **In** weiterer Folge wurden Proben der Elektroden entnommen und mikroskopisch untersucht. Die Ergebnisse verdeutlichen, dass es sich um Ablagerungen von Lithiummetall an der Anode handelt.

Diese Untersuchungen wurden unmittelbar nach dem letzten Entladevorgang, bei welchen drastischen Änderungen der Gruppengeschwindigkeit und der Amplitude beobachtet wurden, durchgeführt. Diese Ergebnisse verdeutlichen, dass mittels Überwachung eines Energiespeichers z.B. einer LIB, mit dem vorgestellten Verfahren, chemische Prozesse, wie zum Beispiel Lithiumplating während der Entstehung detektiert werden können. Im Nachfolgenden wird genau beschrieben, wie diese chemischen Prozesse damit identifiziert und ein weiteres Voranschreiten dieser Vorgänge, welche gegebenenfalls zu sicherheitskritischen Zuständen des Energiespeichers führt, verhindert werden können.

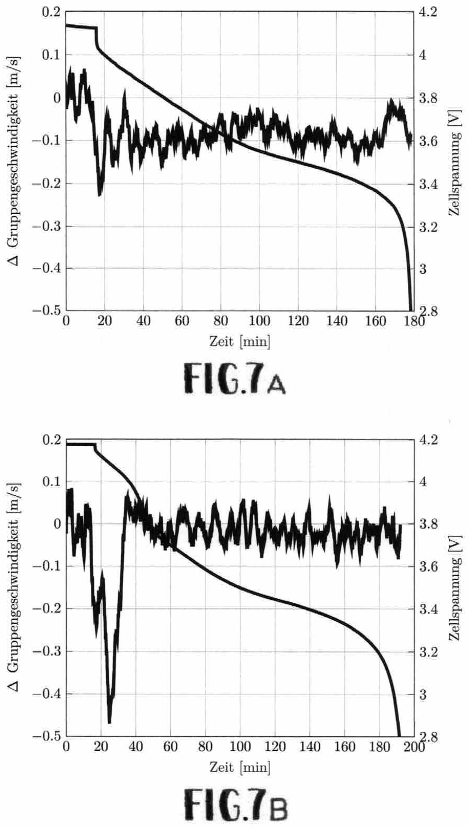

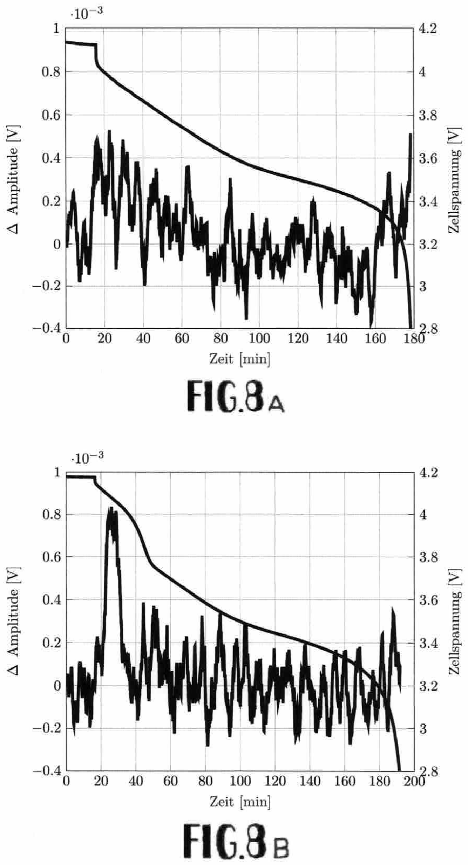

Wie in Fig. 5A, 5B, 6A und 6B ersichtlich ist, ändert sich die Gruppengeschwindigkeit und die Amplitude drastisch, während der Prozess des Lithiumplatings stattfindet. Eine Möglichkeit diesen Vorgang zu detektieren ist es die Rohdaten der Messung mit vorhergehenden Messergebnissen, welche während des Zyklisierens aufgenommen wurden, zu vergleichen. Wenn sich die Werte um einen gewissen Grenzwert bei der gleichen Zellspannung und der gleichen Temperatur drastisch unterscheiden, kann dadurch ein unerwünschter chemischer Prozess wie Lithiumplating detektiert werden. Eine weitere Möglichkeit, welche nicht auf den Informationen vorhergehender Messungen bzw. Ladezyklen beruht, ist die zeitliche Änderung der Gruppengeschwindigkeit bzw. der Amplitude. Diese beiden sind für die Messungen bei Raumtemperatur und bei 10°C in Fig. 7A und 7B sowie Fig. 8A und 8B ersichtlich. Wiederum zeigen die bei t=0 obenliegenden Graphen die Zellspannung (zeitliche Entladung der Batterie 1) an, während die bei t=0 untenliegenden Graphen einmal zeitliche Ableitung der Gruppengeschwindigkeit und einmal die zeitliche Ableitung der Amplitude während des Entladevorgangs über die Zeit darstellen.

Bei Raumtemperatur (Fig. 7A, Fig. 8A) bewegen sich beide Werte in einem ähnlichen Bereich und es sind keine Sprungstellen vorzufinden. Die Messergebnisse bei 10° (Fig. 7B, Fig. 8B) zeigen deutlich, dass sich beide Werte bei einer Zellspannung von ungefähr 4.1V drastisch ändern. Dies ist ein eindeutiges Zeichen, dass zu diesem Zeitpunkt bzw. bei dieser Spannung der chemische Prozess des Lithiumplatings stattfindet. Während des restlichen Entladevorgangs bewegt sich die Änderung der Geschwindigkeit und der Amplitude in einem ähnlichen Bereich. Zum Zeitpunkt des Lithiumplatings verringert bzw. vergrößert sich dieser Wert jedoch drastisch und kann dadurch sehr einfach und ohne jegliches Vorwissen über das Verhalten der **LIB** detektiert werden. Dementsprechend ist es möglich, um Lithiumplating bei Energiespeichern während des Betriebs zu detektieren, die Änderungsraten der Gruppengeschwindigkeit und der Amplitude kontinuierlich zu ermitteln. Falls diese beiden Werte jeweils außerhalb der Bereiche der während des gleichen Ladezyklus gemessenen Änderungsraten sind, tritt der chemische Prozess des Lithiumplatings auf. Diese Information kann in weiterer Folge zum Beispiel an das BMS weitergegeben werden, welches notwendige Betriebsparameter wie Temperatur und Ladestrom anpasst, um dadurch ein Fortschreiten dieses unerwünschten Prozesses zu verhindern. Der wesentliche Vorteil dieser Möglichkeit ist, dass einerseits zwei Messwerte, welche unabhängig von den Messungen der elektrischen Eigenschaften sind, verwendet werden und andererseits keine vorhergehenden Messungen der beschriebenen Methodik zur Charakterisierung der Batterie vorhanden sein müssen, um sicherheitskritische Vorgänge innerhalb des Energiespeichers festzustellen.

Neben den zuvor beschriebenen Möglichkeiten, welche nur auf den Messdaten der Wellenmessung beruhen, besteht natürlich auch die Option, diese Daten mit Informationen bzw. Messdaten aus den elektrischen Eigenschaften bzw. dem elektrischen Zustand der Batterie zu kombinieren (zum Beispiel über das rechnerische Verhältnis von elektrischen Eigenschaften und Ergebnissen der Wellen Messung). Dies kann zum Beispiel durch eine Kombination von Zellspannung mit der gemessenen Ausbreitungsgeschwindigkeit oder Amplitude geschehen, um damit gegebenenfalls eindeutigere Hinweise über den aktuellen Zustand des Lithiumplatings zu erhalten. Letzteres ist ohnehin vorhanden, da diese benötigt wird, um Energiespeicher zu betreiben. Dementsprechend können durch die Kombination aus dem elektrischen Zustand der Batterie 1 und der Gruppengeschwindigkeit bzw. der Amplitude noch eindeutigere Indikatoren für das Auffinden des Zeitpunktes von Lithiumplating erstellt werden, um die Genauigkeit der Methode noch weiter zu erhöhen. Eine dieser Möglichkeiten besteht in einem weiteren Ausführungsbeispiel darin, den Quotienten zwischen der Änderungsrate der Gruppengeschwindigkeit bzw. der Änderungsrate der Amplitude und der Änderungsrate der Zellspannung zu analysieren.

Es gibt eine Vielzahl an Anwendungsmöglichkeiten, diese Methode vorteilhaft zum Einsatz zu bringen. Vor allem in Bereichen, bei welchen die Sicherheit und die Gesundheit von Batterien 1 überwacht werden müssen und ein Versagen des Energiespeichers drastische sicherheitskritische Folgen nach sich ziehen würde.

Eine wichtige Anwendung, welche hohe Kriterien bezüglich Sicherheit vorweist, sind Energiesystem in Elektrofahrzeugen. Das Verfahren kann relativ einfach und kostengünstig an kritischen Stellen eines Batteriepacks implementiert werden und mithilfe eines angepassten BMS zusätzliche Informationen über den Zustand der LIB erzeugen, um nichtgewollte chemische Prozesse zu detektieren. Bei stationären Speichern oder in Mobiltelefonen kann dieses Verfahren ebenfalls eingesetzt werden. Ein weiterer Anwendungsfall, welcher zukünftig vermehrt LIB als Energiespeicher verwenden wird, ist die Luftfahrt. In diesem Bereich muss die Sicherheit und Funktionsfähigkeit von Batteriespeichern durchgehend garantiert werden, weshalb sich die Anwendung dieses Verfahrens sehr gut anbietet. Neben kommerzialisierten Produkten, wo LIB als Energiespeicher eingesetzt werden, kann man diese Technik auch in der Forschung verwenden. Dadurch können bestehende Batterietechnologien optimiert werden, und auch eine genaue Charakterisierung der Sicherheitsgrenzen bzw. Verwendungsparameter ist möglich. Dies beinhaltet neben Forschungsinstituten auch Unternehmen, welche in der gesamten Produktionskette LIB tätig sind. Inkludiert sind zum Beispiel Zulieferer von Automobilherstellern, Hersteller von Zellmaterialien und Hersteller von Batteriepacks. Auch Firmen, welche Produkte mit LIB anbieten und die verwendete Software, beziehungsweise Betriebsparameter für die eigens hergestellte Anwendung optimieren, können mit diesem Verfahren präziser die sicherheitskritischen Grenzen definieren. Da eine LIB aus wertvollen Bestandteilen zusammengesetzt ist, werden diese auch recycelt. Die vorgestellte Methode kann auch in diesem Bereich eingesetzt werden, um genauere Informationen über den aktuellen Zustand des Energiespeichers vor seiner Zerlegung zu erhalten und die rückgewonnenen Bestandteile besser oder individueller aufbereiten zu können. Der wesentliche Vorteil ist, dass sicherheitskritische Prozesse eindeutig und unabhängig vom elektrischen Zweipolverhalten während des Betriebs identifiziert werden können und dadurch die Lebenszeit und auch die Sicherheit des Energiespeichers deutlich verbessert wird. Mögliche Anwendungsgebiete sind das sog. Structural Health Monitoring und Non Destructive Testing, welche häufig als Standard zur Fehlerüberprüfung von Bauteilen angewandt werden.

Die Batterie muss nicht wie in Fig. 1 schematisch dargestellt ein quaderförmiges Zellformat aufweisen. Alternativ kann die Batterie im wesentlichen zylindrisch ausgebildet sein, wobei ihre Außenseite, auf welcher der Emitter T1, der erste Empfänger T2 und ggf. der zweite Empfänger T3 angeordnet sind, durch die Mantelfläche gebildet wird. Dadurch lässt sich das Verfahren auf einem zweiten gängigen geometrischen Körper für Batterien ausführen. Der zweite Empfänger T3, welcher bei einem quaderförmigen Zellformat auf der gegenüberliegenden Seite zum Emitter T1 angeordnet ist, ist bei einem zylindrischen Zellformat um etwa 180° um die Achse des Zylinders gedreht auf der Mantelfläche verschoben.

### Bezugszeichenliste

- 1: Batterie
- 2: Oberseite (der Batterie)
- 3: Unterseite (der Batterie)
- 4: Frequenzgenerator
- 5: Oszilloskop
- 6: Verstärker
- T1: Emitter
- T2: Empfänger
- T3: Empfänger

## Patentansprüche

1. Verfahren zum Bestimmen eines physischen Zustands einer Batterie (1), wobei die Batterie (1) eine Lithium-Ionen Batterie ist und eine Außenseite aufweist, wobei mechanische Wellen im Frequenzbereich von etwa 5 kHz bis etwa 100 kHz mittels mindestens eines Emitters (T1), der auf der Außenseite der Batterie aufgebracht ist, ausgesendet und die Wellen anschließend von mindestens einem ersten Empfänger (T2, T3), der in einem vorbestimmten Abstand (d) vom Emitter auf der Außenseite der Batterie aufgebracht ist, empfangen werden, umfassend die weiteren Schritte:
Zuführen der empfangenen Wellen zu einer Auswerteeinrichtung,
Auswerten der empfangenen Wellen hinsichtlich ihrer Ausbreitungsgeschwindigkeit und/oder ihrer Time of Flight (TOF) zwischen Emitter (T1) und Empfänger (T2, T3),
Auswerten der empfangenen Wellen hinsichtlich ihrer Signalamplituden,
sowie
Errechnen des Zeitpunkts des Anfanges und/oder das Stadium von Lithiumplating der Batterie (1) auf der Basis dieser Auswertungen.

2. Verfahren nach Anspruch 1, **dadurch gekennzeichnet, dass** Informationen aus den elektrischen Eigenschaftender Batterie (1) in die Berechnung ihres Zustandes einbezogen werden.

3. Verfahren nach einem der Ansprüche 1 oder 2, **dadurch gekennzeichnet, dass** ein zweiter Empfänger (T3, T2) auf einer gegenüberliegenden Seite zur Seite des ersten Empfängers (T2, T3) auf der Außenseite der Batterie (1), vorzugsweise lotrecht dem ersten Empfänger (T2, T3) gegenüberliegend, aufgebracht ist, wobei der zweite Empfänger (T3, T2) vorab zur Findung eines geeigneten Signals zu derselben Zeit wie der erste Empfänger (T2, T3) Wellen von mehreren Anregesignalen empfängt und der Auswerteeinrichtung zuführt.

4. Verfahren nach Anspruch 3, **dadurch gekennzeichnet, dass** die Auswertung der empfangenen Wellen hinsichtlich der Moden von Lambwellen erfolgt.

5. Verfahren nach einem der Ansprüche 1 bis 4, **dadurch gekennzeichnet, dass** der Emitter (T1) einen Puls von Wellen aussendet, der vorzugsweise in Form einer Einhüllenden moduliert ist.

6. Verfahren nach Anspruch 5, **dadurch gekennzeichnet, dass** der ausgesendete Puls von Wellen etwa drei bis etwa acht, vorzugsweise etwa fünf Perioden lang ist.

7. Verfahren nach einem der Ansprüche 1 bis 6, **gekennzeichnet durch** die weiteren Schritte:
Speichern der Resultate zeitlich aufeinanderfolgender Messungen, insbesondere von Amplitude und/oder Ausbreitungsgeschwindigkeit,
Errechnen eines physischen Parameters aus dem zeitlichen Verlauf der Resultate.

8. Verfahren nach einem der Ansprüche 1 bis 7, **dadurch gekennzeichnet, dass** vor der Errechnung des physischen Zustands eine Eichmessung durchgeführt wird, deren Ergebnis in der Auswerteeinrichtung gespeichert wird.

9. Verfahren nach einem der Ansprüche 1 bis 8, **dadurch gekennzeichnet, dass** die Batterie (1) ein Batterie-Managementsystem, BMS, sowie eine elektronische Messeinrichtung aufweist, wobei die elektronische Messeinrichtung den Emitter (T1), den ersten (T2) und ggf. den zweiten vorhandenen Empfänger (T3) steuert, wobei ferner die elektronische Messeinrichtung die Auswerteeinrichtung umfasst, in der die Auswertungsschritte erfolgen.

10. Verfahren nach Anspruch 9, wobei die elektronische Messeinrichtung dem BMS Messergebnisse mitteilt.

11. Verfahren nach Anspruch 9 oder 10, **dadurch gekennzeichnet, dass** die von der elektronischen Messeinrichtung gesteuerten Signale an den Emitter (T1) und/oder die empfangenen Signale des oder der Empfänger (T2, T3) vor der Auswertung elektrisch verstärkt werden.

12. Verfahren nach einem der Ansprüche 9 bis 11, **dadurch gekennzeichnet, dass** das BMS der Batterie (1) auf der Basis des errechneten Zustandes die Batterie (1) einen Aufladevorgang, einen Entladevorgang, eine Heizaktion, eine Signalabgabe und/oder eine Abschaltung auslöst.

13. Verfahren nach einem der Ansprüche 1 bis 12, **dadurch gekennzeichnet, dass** die Batterie (1) im wesentlichen quaderförmig ausgebildet ist sowie eine Ober- und eine Unterseite (2, 3) aufweist, wobei der Emitter (T1) auf der Oberseite (2) und der erste Empfänger auf der Oberseite (2) oder der Unterseite (3) der Batterie (1) aufgebracht ist.

14. Verfahren nach einem der Ansprüche 1 bis 12, **dadurch gekennzeichnet, dass** die Batterie (1) im wesentlichen zylindrisch ausgebildet ist, deren Außenseite, auf welcher der Emitter (T1), der erste Empfänger (T2) und ggf. der zweite Empfänger (T3) angeordnet sind, durch die Mantelfläche gebildet wird.
